# EUROPEAN PATENT SPECIFICATION

(11) **EP 3 425 569 B1**
(45) Date of publication and mention of the grant of the patent: **20.05.2020**
(21) Application number: 18180254.7
(22) Date of filing: 27.06.2018
(51) Int. Cl.: G06K 19/067

(54) **TAMPER EVIDENT SEAL INCORPORATING FLEXIBLE MEMORY DEVICES**
ORIGINALITÄTSVERSCHLUSS MIT FLEXIBLEN SPEICHERVORRICHTUNGEN
JOINT D'ÉTANCHÉITÉ INVIOLABLE INCORPORANT DES DISPOSITIFS DE MÉMOIRE SOUPLE

(30) Priority: 05.07.2017 US 201715641694
(43) Date of publication of application: 09.01.2019
(73) Proprietor: Xerox Corporation, Webster, NY 14580 (US)
(72) Inventor: STUCKEY, Aaron M., Fairport, NY New York 14450 (US); FOWLER, Jeffrey M., Rochester, NY New York 14625 (US); TRIVEDI, Amit, Webster, NY New York 14580 (US); KURZ, Karl E., Rochester, NY New York 14622 (US)
(74) Representative: Gill Jennings & Every LLP

(56) References cited:
- US-A1- 2010 181 371
- US-A1- 2014 263 659
- US-A1- 2017 068 830

## Description

### TECHNICAL FIELD

The presently disclosed embodiments are directed to providing a flexible memory device, more particularly to a product seal, tag and/or tracking means including a flexible memory device, and even more particularly to a product seal, tag and/or tracking means including a flexible memory device that evidences tampering or modification, e.g., intentional and/or selective lead destruction, while maintaining a portion of data stored in the memory device.

### BACKGROUND

Flexible memory devices, e.g., printed memory (PM) labels and devices, are manufactured in a variety of sizes, including but not limited to twenty bit (20-bit), twenty-five bit (25-bit) and thirty-six bit (36-bit), which each have various arrangements of electrical contacts or contact pads. An example of a known 20-bit printed memory device is depicted in Figure 1 which corresponds to the device described in US-A-2017/0068830. Claim 1 is delimited against this document. As is known in the art, printed memory devices typically comprise seven layers: a base substrate layer; a bottom electrode layer; a ferrite layer; a top electrode layer; contact pads; a soft protective layer; and, a hard protective layer. The ferrite layer is arranged between the bottom and top electrode layers. Memory is stored in a discrete cell, i.e., a particular portion of the ferrite layer, an appropriate voltage pattern must be applied across contact pads connected to the bottom and top electrode layers associated with the particular portion of the ferrite layer. Other known devices are described in US-A-2010/181371 and US-A-2014/263659.

Products and product packaging may be subjected to tampering or counterfeiting. Products such as popular liquors and cigarettes, for example, are at times adulterated or replaced with knock off products in order for others to profit from the theft and deception. Thus, there is a need for a device that can both seal a product and ensure the product is what it is intended to be.

The present disclosure sets forth a seal or tag containing a flexible memory device that can be disabled in whole or in part so that any tampering after the product has left the original manufacturer is detectable. It makes it possible to track if the seal or tag has been broken post manufacture. Moreover, information about the product or the status of the product retained in memory, before and after the seal or tag, or a portion of the seal or tag, is broken can further minimize the foregoing issues. Tampering with the product and breaking the seal or tag may disable the ability to read part or all of the information stored in the flexible memory device.

### SUMMARY

This invention proposes to re-route one or more leads in a flexible memory device such that they connect memory cells to contact pads via a perforated area. When the perforation is torn, the connection is broken between the memory cells and the contact pad.

Broadly, the present disclosure sets forth embodiments of a flexible memory device including a flexible substrate, a plurality of contact pads, a plurality of lines and a first partially weakened portion of the flexible substrate. The plurality of contact pads are disposed on the flexible substrate. At least one contact pad of the plurality of contact pads forms at least one tamper evident contact pad. The plurality of lines are disposed on the flexible substrate, each line of the plurality of lines connected to a contact pad of the plurality of contact pads. At least one line of the plurality of lines forms at least one first tamper evident line and is connected to the at least one first tamper evident contact pad. The first partially weakened portion of the flexible substrate is arranged across the at least one tamper evident line.

Other objects, features and advantages of one or more embodiments will be readily appreciable from the following detailed description and from the accompanying drawings and claims.

### BRIEF DESCRIPTION OF THE DRAWINGS

Various embodiments are disclosed, by way of example only, with reference to the accompanying drawings in which corresponding reference symbols indicate corresponding parts, in which:
Figure 1 is a top plan view of an embodiment of a known 20-bit flexible memory device;
Figure 2 is a top plan view of an embodiment of a 20-bit tamper evident flexible memory device;
Figure 3 is a top plan view of an embodiment of a 20-bit tamper evident flexible memory device;
Figure 4 is a top plan view of an embodiment of a 20-bit tamper evident flexible memory device;
Figure 5 is top plan view of an embodiment of a known 25-bit flexible memory device;
Figure 6 is a top plan view of an embodiment of a 25-bit tamper evident flexible memory device;
Figure 7 is a top plan view of an embodiment of a 25-bit tamper evident flexible memory device;
Figure 8 is a table depicting various configurations for an embodiment of a 25-bit tamper evident flexible memory device, wherein 5-25 bits may be disabled or obscured by interrupting 1-8 leads;
Figure 9 is a top plan view of an embodiment of a known 36-bit flexible memory device;
Figure 10 is a top plan view of an embodiment of a 36-bit tamper evident flexible memory device;
Figure 11 is a top plan view of an embodiment of a 36-bit tamper evident flexible memory device;
Figure 12 is a top plan view of an embodiment of a 36-bit tamper evident flexible memory device;
Figure 13 is a top plan view of an embodiment of a 25-bit tamper evident flexible memory device;
Figure 14 is a side elevational view of an embodiment of a 25-bit tamper evident flexible memory device;
Figure 15 is a back elevational view of an embodiment of a packaging bag including an embodiment of a 25-bit tamper evident flexible memory device; and,
Figure 16 is a side elevational view of an embodiment of a container including an embodiment of a 25-bit tamper evident flexible memory device.

### DETAILED DESCRIPTION

At the outset, it should be appreciated that like drawing numbers on different drawing views identify identical, or functionally similar, structural elements of the embodiments set forth herein. Furthermore, it is understood that these embodiments are not limited to the particular methodologies, materials and modifications described and as such may, of course, vary. It is also understood that the terminology used herein is for the purpose of describing particular aspects only, and is not intended to limit the scope of the disclosed embodiments, which are limited only by the appended claims.

Unless defined otherwise, all technical and scientific terms used herein have the same meaning as commonly understood to one of ordinary skill in the art to which these embodiments belong. As used herein, "weakened portion", for example a weakened portion of a flexible substrate, is intended to mean a portion of an original structure that has been modified, altered or formed in such a way that a force required to sever the weakened portion is less than the severing force required for the original structure. Examples of "weakened portions" include but are not limited to perforations, notches, partial cuts, decreased material thickness, *etc.*

It should be understood that use of "or" in the present application is with respect to a "non-exclusive" arrangement, unless stated otherwise. For example, when saying that "item x is A or B," it is understood that this can mean one of the following: (1) item x is only one or the other of A and B; (2) item x is both A and B. Alternately stated, the word "or" is not used to define an "exclusive or" arrangement. For example, an "exclusive or" arrangement for the statement "item x is A or B" would require that x can be only one of A and B. Furthermore, as used herein, "and/or" is intended to mean a grammatical conjunction used to indicate that one or more of the elements or conditions recited may be included or occur. For example, a device comprising a first element, a second element and/or a third element, is intended to be construed as any one of the following structural arrangements: a device comprising a first element; a device comprising a second element; a device comprising a third element; a device comprising a first element and a second element; a device comprising a first element and a third element; a device comprising a first element, a second element and a third element; or, a device comprising a second element and a third element.

Moreover, although any methods, devices or materials similar or equivalent to those described herein can be used in the practice or testing of these embodiments, some embodiments of methods, devices, and materials are now described.

The present disclosure sets forth various embodiments of flexible memory devices, e.g., flexible printed memory devices, arranged to evidence tampering and/or arranged to positively indicate the occurrence of an action, e.g., inspection of an article.

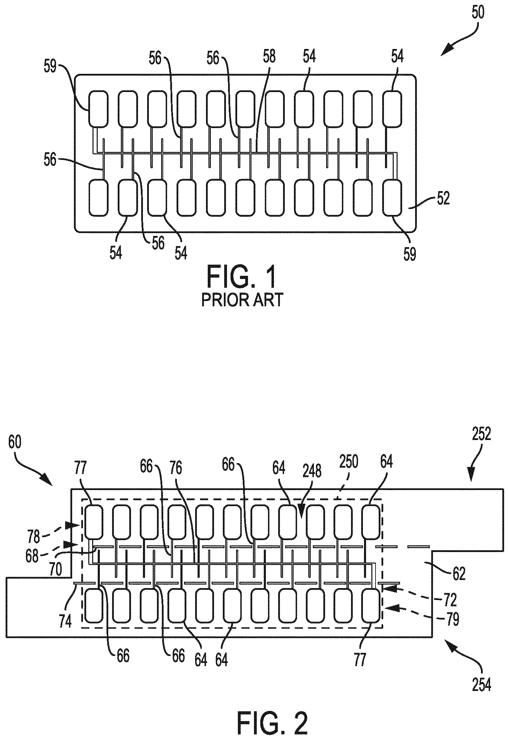

Figure 1 depicts an embodiment of a known 20-bit flexible memory device, i.e., printed memory device **50.** Device **50** includes flexible substrate **52** having contact pads **54** and lines **56** disposed thereon. Common line **58,** connected to contact pads **59,** is separated from lines **56** by a ferrite layer as described above, and lines **56** are connected to contact pads **54.** A single bit of memory is formed by each portion of the ferrite layer located at the depicted intersections of common line **58** and lines **56.**

Figure 2 depicts an embodiment of a presently described 20-bit tamper evident flexible memory device **60.** Device **60** comprises flexible substrate **62** having contact pads **64** and interconnecting lines **66** disposed thereon. Moreover, device **60** comprises a plurality of leads or lines routed across a first perforation, and a plurality of leads or lines routed across a second perforation. In other terms, tamper evident lines **68** are routed across weakened portion **70,** while tamper evident lines **72** are routed across weakened portion **74.** Common line **76** is connected to contact pads 77 and is separated from lines 66 by a ferrite layer as described above.

In an example embodiment, a write operation would write a 0 value to tamper evident contact pads **78** connected to tamper evident lines **68.** When perforation **70** is torn or severed, a read operation will yield a value of 1 for these bits, regardless of the 0 value that was originally written. In this example embodiment, the bits of memory act to detect whether perforation **70** has been torn or severed, i.e., whether flexible memory device **60** was subject to tampering or its associated packaging opened. Moreover, if a second indication of tampering is required, device **60** may also be arranged such that perforation **74** may be severed simultaneously as or at a different time than perforation **70,** thereby permitting a similar instance of bit storage for tamper evident contact pads **79.**

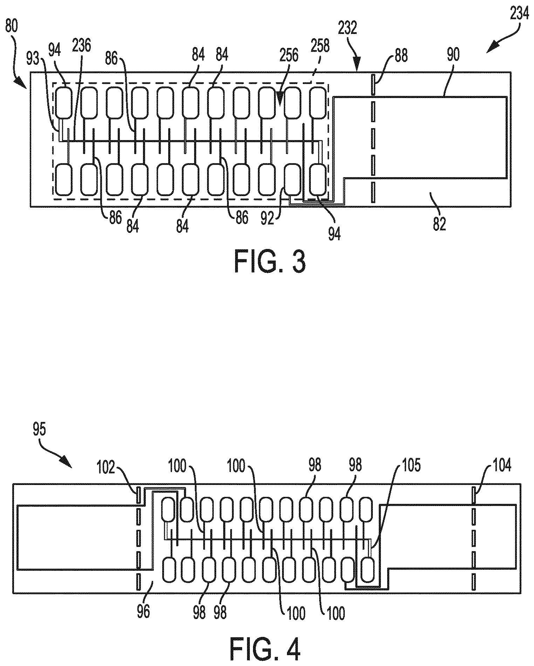

It should be appreciated that the foregoing arrangement of tamper evident contact pads and tamper evident lines is not limited to embodiments where all lines on a particular side of device **60** are simultaneously severed. For example, Figure 3 depicts a 20-bit tamper evident flexible memory device, i.e., device **80.** Device **80** includes flexible substrate **82** having contact pads **84** and lines **86** thereon, and further includes weakened portion **88** therethrough. In this embodiment, tamper evident line **90** is the only line passing across weakened portion **88.** Thus, severing weakened portion **88** severs tamper evident line **90** thereby altering the bit value readable from tamper evident contact pad **92,** while the remaining lines **86** and common line **93** are not severed. It should be appreciated that contact pads **94** are connected to common line **93,** while contact pads **84** are connected to lines **86.** Moreover, Figure 4 depicts an embodiment of a 20-bit tamper evident flexible memory device **95** including flexible substrate **96** having contact pads **98** and lines **100** thereon, and further includes weakened portions **102** and **104** therethrough. In this embodiment, two levels or instances of change may be detected, i.e., the severing of weakened portion **102** (the first instance) and the severing of weakened portion **104** (the second instance). Similar to the embodiment depicted in Figure 3, both instances result in common line **105** and at least a portion of lines **100** remaining intact.

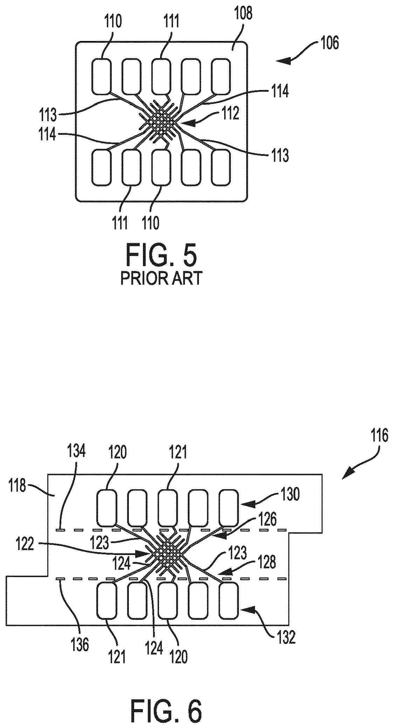

Figure 5 depicts an embodiment of a known 25-bit flexible memory device, i.e., printed memory device **106.** Device **106** includes flexible substrate **108** having contact pads **110,** contact pads **111** and lines **112** disposed thereon. Lines **112** comprise a first portion, i.e., lines **113,** connected to contact pads **110** and a second portion, i.e., lines **114,** connected to contact pads **111.** It should be appreciated that lines **113** are arranged to pass over lines **114** with a ferrite layer disposed therebetween, as described above with respect to other embodiments. A single bit of memory is formed by each portion of the ferrite layer located at the depicted intersections of lines **113** and lines **114.**

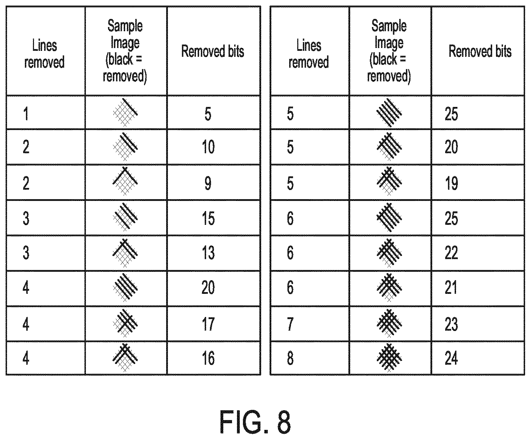

Figure 6 depicts an embodiment of a 25-bit tamper evident flexible memory device, i.e., device **116.** Device **116** comprises flexible substrate **118** having contact pads **120,** contact pads **121** and lines **122** disposed thereon. Lines **122** comprise a first portion, i.e., lines **123,** connected to contact pads **120** and a second portion, i.e., lines **124,** connected to contact pads **121.** It should be appreciated that lines **123** are arranged to pass over lines **124** with a ferrite layer disposed therebetween, as described above with respect to other embodiments. A single bit of memory is formed by each portion of the ferrite layer located at the depicted intersections of lines **123** and lines **124.** In this embodiment, a portion of lines **123** and a portion of lines **124** are tamper evident lines **126** while the remaining lines **123** and **124** are tamper evident lines **128.** Each of tamper evident lines **126** is connected to tamper evident contact pad **130** at a first end, while each of tamper evident lines **128** is connected to tamper evident contact pad **132** at a first end. Tamper evident lines **126** each pass across weakened portion **134,** and tamper evident lines **128** each pass across weakened portion **136.** By severing one of weakened portions **134** or **136,** device **116** retains some quantity of data bits in accordance with the depiction in Figure 8 and the discussion related thereto below, while severing both of weakened portions **134** and **136,** device **116** obscures all of the stored data bits.

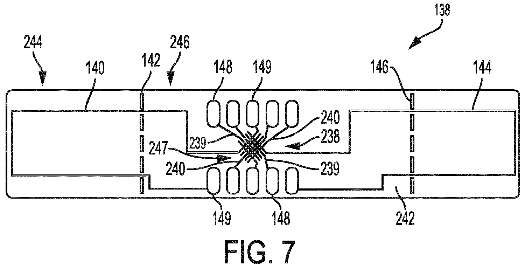

Figure 7 depicts an embodiment of a 25-bit tamper evident flexible memory device, i.e., device **138.** Device **138** comprises two leads or lines routed across two different perforations or weakened portions. In other terms, tamper evident line **140** is routed across weakened portion **142,** while tamper evident line **144** is routed across weakened portion **146.** In this example embodiment, contact pads **148** and **149** are formed in rows, and there is one tamper evident line that is disabled by tearing either perforation. Four additional bits are disabled by tearing perforation or weakened portion **142,** and a further four additional bits are disabled by tearing perforation or weakened portion **146.** The foregoing arrangement facilitates a variety of uses for device **138.** For example, device **138** may be secured to a product packaging and facilitate the recording of the passage of the product through two stages of a process, while obscuring some of the data used earlier in the process. In other terms, data bits may be written to device **138** at the onset. Subsequently, device **138** is attached to a product or product packaging. As the product moves through its process, weakened portion **142** is severed to obscure a portion of the data bits stored on device **138,** while retaining other data bits. Then, later in the process, weakened portion **146** is severed thereby obscuring additional bits of data.

Figure 8 depicts various configurations available for a 25-bit flexible memory device, by which 5-25 bits may be disabled or obscured by interrupting 1-8 leads. It should be appreciated that Figure 8 does not depict all possible arrangements of severing lines, but depicts a set of non-limiting examples. The table in Figure 8 shows how removing the same number of lines can result in differing numbers of removed bits, e.g., removing four lines could result in removing 16, 17 or 20 bits.

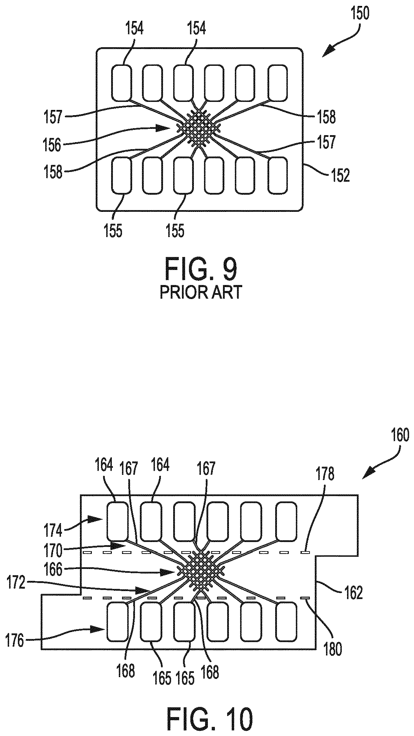

Figure 9 depicts a known 36-bit flexible memory device, i.e., device **150.** Device **150** includes flexible substrate **152** having contact pads **154,** contact pads **155** and lines **156** disposed thereon. Lines **156** comprise a first portion, i.e., lines **157,** connected to contact pads **154** and a second portion, i.e., lines **158,** connected to contact pads **155.** It should be appreciated that lines **157** are arranged to pass over lines **158** with a ferrite layer disposed therebetween, as described above with respect to other embodiments. A single bit of memory is formed by each portion of the ferrite layer located at the depicted intersections of lines **157** and lines **158.**

Figure 10 depicts an embodiment of a 36-bit tamper evident flexible memory device, i.e., device **160.** Device **160** comprises flexible substrate **162** having contact pads **164,** contact pads **165** and lines **166** disposed thereon. Lines **166** comprise a first portion, i.e., lines **167,** connected to contact pads **164** and a second portion, i.e., lines **168,** connected to contact pads **165.** It should be appreciated that lines **167** are arranged to pass over lines **168** with a ferrite layer disposed therebetween, as described above with respect to other embodiments. A single bit of memory is formed by each portion of the ferrite layer located at the depicted intersections of lines **167** and lines **168.** In this embodiment, a portion of lines **167** and a portion of lines **168** are tamper evident lines **170** while the remaining lines **167** and **168** are tamper evident lines **172.** Each of tamper evident lines **170** is connected to tamper evident contact pad **174** at a first end, while each of tamper evident lines **172** is connected to tamper evident contact pad **176.** Tamper evident lines **170** each pass across weakened portion **178,** and tamper evident lines **172** each pass across weakened portion **180.** By severing one of weakened portions **178** or **180,** device **160** retains some quantity of data bits in accordance with the depiction in Figure 8 and the discussion related thereto above, while severing both of weakened portions **178** and **180,** device **160** obscures all of the stored data bits.

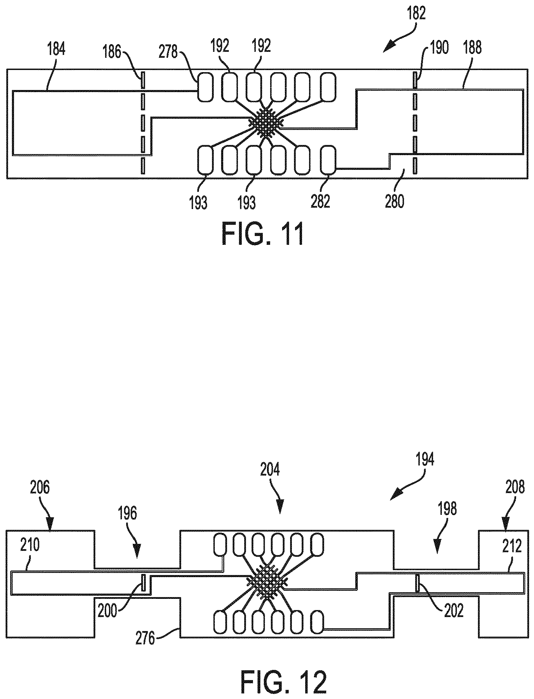

Figure 11 depicts an embodiment of a 36-bit tamper evident flexible memory device, i.e., device **182.** Device **182** comprises two leads or lines routed across two different perforations or weakened portions. In other terms, tamper evident line **184** is routed across weakened portion **186,** while tamper evident line **188** is routed across weakened portion **190.** In this example embodiment, contact pads **192** and **193** are formed in rows. The foregoing arrangement facilitates a variety of uses for device **182,** for example, uses as described above relative to Figure 7.

Figure 12 depicts an embodiment of a 36-bit tamper evident flexible memory device, i.e., device **194.** Device **194** depicted in Figure 12 is configured substantially the same as device **182** depicted in Figure 11; however, device **194** includes narrowed regions **196** and **198** having weakened portions **200** and **202,** respectively, arranged therein. The shape of device **194** makes it appropriate for placing over the top of a bottle or jar, such that at least one perforation or weakened portion **200** and/or **202** is torn when the container is opened. In other terms, central portion **204** is secured to the top of a bottle, for example, while distal portions **206** and **208** are secured to the body of the bottle adjacent the top. When the bottle is opened, one or both of weakened portions **200** and/or **202** are severed thereby severing tamper evident leads **210** and/or **212,** and narrowed regions **196** and/or **198.**

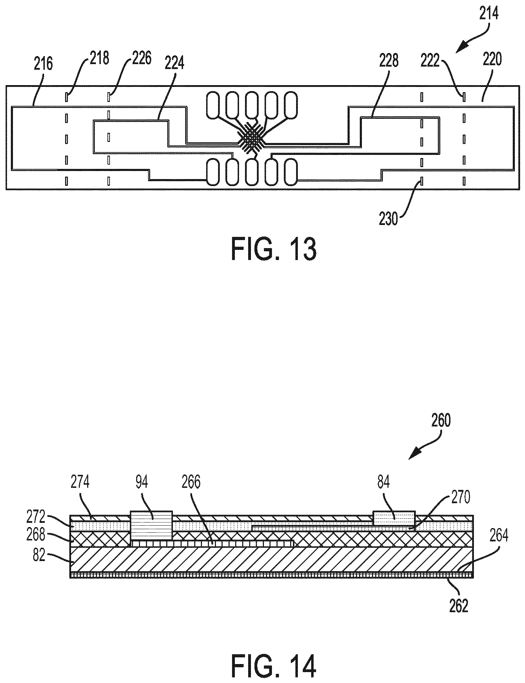

Figure 13 depicts an embodiment of a 25-bit tamper evident flexible memory device, i.e., device **214.** Device **214** comprises four leads or lines routed across four different perforations or weakened portions. In other terms, tamper evident line **216** is routed across weakened portion **218,** tamper evident line **220** is routed across weakened portion **222,** tamper evident line **224** is routed across weakened portion **226,** and tamper evident line **228** is routed across weakened portion **230.** The foregoing arrangement facilitates a variety of uses for device **214.** For example, device **214** may be secured to a product packaging and facilitate the recording of the passage of the product through four stages of a process, while obscuring some of the data used earlier in the process. In other terms, data bits may be written to device **214** at the onset. Subsequently, device **214** is attached to a product or product packaging. As the product moves through its process, weakened portion **218** is severed to obscure a portion of the data bits stored on device **214,** while retaining other data bits. Then, later in the process, weakened portions **222, 226** and **230** are severed thereby obscuring additional bits of data.

The following is best understood in view of the accompanying figures, which figures are individually described in greater detail above. The present disclosure sets forth various embodiments of flexible memory devices, e.g., flexible printed memory devices arranged to evidence tampering and/or arranged to positively indicate the occurrence of an action, e.g., inspection of an article. Although the embodiments described below may discuss elements contained within a single figure, the embodiments are not limited to a single configuration, and various aspects of some embodiments may be combined with various aspects of other embodiments.

In some embodiments, flexible memory device **80** comprises flexible substrate **82,** plurality of contact pads **84,** plurality of lines **86** and partially weakened portion **88** of flexible substrate **82.** Plurality of contact pads **84** are disposed on flexible substrate **82.** At least one contact pad of plurality of contact pads **84** forms at least one tamper evident pad, e.g., tamper evident pad **92.** Plurality of lines **86** are disposed on flexible substrate **82** and each line **86** passes over common line **93,** as described above, i.e., with a ferrite layer therebetween. At least one line of plurality of lines **86** forms at least one first tamper evident line, e.g., tamper evident line **90.** Partially weakened portion **88** of flexible substrate **82** is arranged across the at least one tamper evident line **90.**

In some embodiments, plurality of contact pads **84** and plurality of lines **86** are arranged to store a plurality of bits of data. It should be appreciated that the manufacture and encoding of flexible memory devices such as printed memory devices are generally known, and therefore, a detailed description of these aspects is unnecessary.

In some embodiments, partially weakened portion **88** is arranged to separate flexible substrate **82** into first part **232** and second part **234** thereby severing the at least one tamper evident line **90** and the at least one tamper evident pad **92** from plurality of contact pads **84** other than the at least one tamper evident pad **92** and plurality of lines **86** other than the at least one tamper evident line **90.** In some embodiments, plurality of contact pads **84** other than the at least one tamper evident pad **92** and plurality of lines **86** other than the at least one tamper evident line **90** store at least one bit of data after severing the at least one tamper evident line **90.**

In some embodiments, each of plurality of lines **86** passes over common line **236,** as described above, i.e., with a ferrite layer therebetween. In some embodiments, partially weakened portion **88** is arranged to separate flexible substrate **82** into first part **232** and second part **234** without severing common line **236** (See, e.g., Figure 3).

In some embodiments, plurality of lines **238** comprises a first portion, i.e., lines **239,** which pass over a second portion, i.e., lines **240.** In some embodiments, partially weakened portion **142** is arranged to separate flexible substrate **242** into first part **244** and second part **246** without severing an area, i.e., area **247,** common to lines **239** and **240** (See, e.g., Figure 7).

In some embodiments, plurality of contact pads **64** and **77** collectively form an area, e.g., area **248** bound by dashed line **250,** and partially weakened portion **70** is arranged across area **248** (See, e.g., Figure 2).

In some embodiments, partially weakened portion **70** is arranged to separate flexible substrate **62** into first part **252** and second part **254,** a first group of plurality of contact pads **64** are disposed on first part **252,** e.g., contact pads **78,** and a second group of plurality of contact pads **64** are disposed on second part **254,** e.g., contact pads **79** (See, e.g., Figure 2).

In some embodiments, plurality of contact pads **84** collectively form an area, e.g., area **256** bound by dashed line **258,** and partially weakened portion **88** is arranged outside area **256** (See, e.g., Figure 3).

In some embodiments, partially weakened portion **88** is arranged to separate flexible substrate **82** into first part **232** and second part **234** and plurality of contact pads **84** are disposed on first part **232** (See, e.g., Figure 3).

In some embodiments, the presently described flexible memory device **260** comprises adhesive layer **262,** e.g., pressure sensitive adhesive, disposed on at least a portion of first surface **264** of flexible substrate **82.** Printed memory device **260** comprises seven layers: base substrate layer **82;** bottom electrode layer **266;** ferrite layer **268;** top electrode layer **270;** contact pads **84** and **94;** soft protective layer **272;** and, hard protective layer **274.** Ferrite layer **268** is arranged between bottom and top electrode layers **266** and **270,** respectively. In some embodiments, partially weakened portion **88** is arranged to separate flexible substrate **82** into first part **232** and second part **234,** and adhesive **260** is disposed on first part **232.** In some embodiments, partially weakened portion **88** is arranged to separate flexible substrate **82** into first part **232** and second part **234,** and adhesive **260** is disposed on a portion of first part **232,** e.g., the portion including area **256.**

In some embodiments, flexible substrate **276** comprises first part **206,** second part **208** and third part **204.** Third part **204** is arranged between first and second parts **206** and **208,** respectively. Partially weakened portion **200** is arranged between third part **204** and first part **206,** and/or partially weakened portion **202** is arranged between third part **204** and second part **208,** and adhesive **260** is disposed on at least a portion of first part **206,** at least a portion of second part **208** and/or at least a portion of third part **204.**

In some embodiments, the presently described flexible memory device comprises at least one first tamper evident contact pad selected from plurality of contact pads, e.g., tamper evident contact pad **278,** at least one first tamper evident line selected from plurality of lines, e.g., tamper evident line **184,** and connected to the at least one first tamper evident contact pads **278,** and further comprising a first partially weakened portion, e.g., weakened portion **186,** of flexible substrate **280** arranged across the at least one first tamper evident line, e.g., tamper evident line **184.** Additionally, the foregoing flexible memory device comprises at least one second tamper evident contact pad selected from plurality of contact pads, e.g., tamper evident contact pad **282,** at least one second tamper evident line selected from plurality of lines, e.g., tamper evident lines **188,** and connected to the at least one second tamper evident contact pad **282,** and further comprising a second partially weakened portion, e.g., weakened portion **190,** of flexible substrate **280** arranged across the at least one second tamper evident line, e.g., tamper evident line **188.**

It should be appreciated that the flexible memory devices described herein may be used in a variety of applications. The following provides some non-limiting examples of how and where the present flexible memory devices may be used.

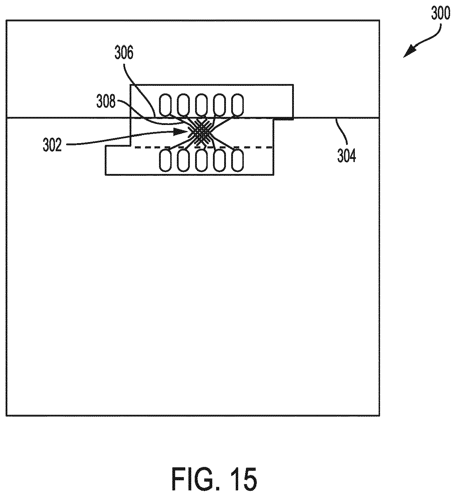

Figure 15 depicts an embodiment of a packaging bag, i.e., bag **300,** including an embodiment of a 25-bit tamper evident flexible memory device, i.e., flexible memory device **302.** Bag **300** may be sealed along edge **304** thereby preventing access to the contents of bag **300.** Weakened portion **306** of flexible memory device **302** must be severed in order to gain access to the contents. Thus, tampering with bag **300** and potentially the contents therein is readily apparent upon reading the memory stored in flexible memory device **300.** As described above, the memory stored in flexible memory device **300** is altered when weakened portion **306** is severed thereby severing tamper evident line **308.**

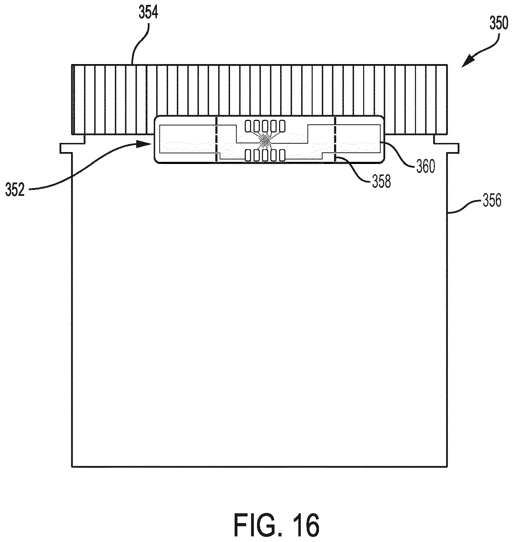

Figure 16 depicts an embodiment of a container, e.g., pill bottle **350,** including an embodiment of a 25-bit tamper evident flexible memory device, i.e., flexible memory device **352.** Pill bottle **350** may be sealed along the interface between cap **354** and bottle **356** thereby preventing access to the contents of pill bottle **350.** Weakened portion **358** of flexible memory device **352** must be severed in order to gain access to the contents. Thus, tampering with pill bottle **350** and potentially the contents therein is readily apparent upon reading the memory stored in flexible memory device **352.** As described above, the memory stored in flexible memory device **352** is altered when weakened portion **358** is severed thereby severing tamper evident line **360.**

It should be appreciated that the foregoing examples are non-limiting and that other configurations and uses of the present flexible memory device are also possible. For example, more than one weakened portion may be utilized in preventing tampering with a container's contents. Additionally, other structures or enclosures different than a bag or a pill bottle may be used in combination with a present flexible memory device or devices, e.g., a compact disc jewel case, shipping packages, a carton, a box, a crate, a can, a bottle, an envelope, etc.

Although the various embodiments depicted in the figures and discussed herein include 20-bit, 25-bit and 36-bit flexible memory devices, the presently described flexible memory devices may be used with other embodiments, e.g., 16-bit, or with other memory technologies, including but not limited to write-once printed memory. Depending on configuration, tearing or separating the perforation or weakened portion may disable 0-20 bits of the 20-bit memory, 5-25 bits of the 25-bit memory, or 6-36 bits of the 36-bit memory. In some applications, the presently described flexible memory device permits detection of the tear or severing operation, or alternatively more than one tear or severing operations, while maintaining the function of a portion of the stored memory or data bits on the device. In some applications, the presently described flexible memory device obscures some or all of the stored memory or data bits on the flexible memory device. Moreover, intermediate use cases are also supported. For example, a 25-bit flexible memory device may be configured so that tearing or severing the perforation, i.e., weakened portion, obscures 11 bits of data while leaving 14 bits functional. In other terms, 14 bits of data would remain available for subsequent retrieval from the flexible memory device.

In view of the foregoing it should be appreciated that present disclosure sets forth a tear-able or severable sealing and/or label design using a flexible memory device. Some memory devices, e.g., printed memory devices, are accessed by a memory reader touching contact pads that are printed on a flexible substrate. In such devices, printed conductive traces between the contact pads and the memory device are printed across perforations or weakened portions in the substrate so that strategic bits in the memory device can be made inaccessible by or obscured from the memory reader once the flexible substrate has been torn or severed along the weakened portion. In this way, some memory locations remain functional, while others are rendered non-functional due to the severing or removal of a portion of the substrate. Thus, the

In view of the foregoing it should be appreciated that present disclosure sets forth a tear-able or severable sealing and/or label design using a flexible memory device. Some memory devices, e.g., printed memory devices, are accessed by a memory reader touching contact pads that are printed on a flexible substrate. In such devices, printed conductive traces between the contact pads and the memory device are printed across perforations or weakened portions in the substrate so that strategic bits in the memory device can be made inaccessible by or obscured from the memory reader once the flexible substrate has been torn or severed along the weakened portion. In this way, some memory locations remain functional, while others are rendered non-functional due to the severing or removal of a portion of the substrate. Thus, the presently described flexible memory device provides the ability to selectively disable certain memory locations of the device by tearing/severing/removing a portion of the flexible substrate.

## Claims

1. A flexible memory device (60) comprising:
a flexible substrate (62);
a plurality of contact pads (64) disposed on the flexible substrate (62);
a plurality of lines (66) disposed on the flexible substrate (62), each line of the plurality of lines (66) connected to a contact pad of the plurality of contact pads (64);
**characterised in that**:
at least one contact pad of the plurality of contact pads (64) forms at least one first tamper evident contact pad (78);
at least one line of the plurality of lines (66) forms at least one first tamper evident line (68) and is connected to the at least one tamper evident contact pad (78);
a first partially weakened portion (70) of the flexible substrate (62) arranged across the at least one tamper evident line (68).

2. The flexible memory device of Claim 1 wherein the plurality of contact pads (64) and the plurality of lines (68) are arranged to store a plurality of bits of data.

3. The flexible memory device of Claim 1 wherein the first partially weakened portion (70) is arranged to separate the flexible substrate (62) into a first part and a second part thereby severing the at least one tamper evident line (68) while leaving the plurality of lines other than the at least one tamper evident line intact.

4. The flexible memory device of Claim 3 wherein the plurality of contact pads (64) other than the at least one first tamper evident contact pad (78) and the plurality of lines (66) other than the at least one tamper evident line (68) store at least one bit of data after severing the at least one tamper evident line (68).

5. The flexible memory device of Claim 1 further comprising:
two common contact pads (77);
a common line (76) disposed on the flexible substrate (62) and connected to the two common contact pads (77);
wherein each of the plurality of lines (66) passes over the common line (76).

6. The flexible memory device of Claim 5 wherein the first partially weakened portion (70) is arranged to separate the flexible substrate into a first part and a second part without severing the common line (77).

7. The flexible memory device of Claim 1 wherein a first portion (123) of the plurality of lines passes over a second portion (124) of the plurality of lines, and each line of the first portion passes over each line of the second portion.

8. The flexible memory device of Claim 7 wherein the first partially weakened portion is arranged to separate the flexible substrate into a first part and a second part without severing an area common to the first portion of the plurality of lines passing over the second portion of the plurality of lines.

9. The flexible memory device of Claim 1 wherein the plurality of contact pads (64) collectively form an area, and the first partially weakened portion (70) is arranged across the area.

10. The flexible memory device of Claim 1 wherein the first partially weakened portion (70) is arranged to separate the flexible substrate (62) into a first part and a second part, a first group of the plurality of contact pads are disposed on the first part and a second group of the plurality of contact pads are disposed on the second part.

11. The flexible memory device of Claim 1 wherein the plurality of contact pads (64) collectively form an area, and the first partially weakened portion (88) is arranged outside the area.

12. The flexible memory device of Claim 1 wherein the first partially weakened portion (88) is arranged to separate the flexible substrate into a first part and a second part and the plurality of contact pads (64) are disposed on the first part.

13. The flexible memory device of Claim 1 further comprising:
at least one second tamper evident contact pad selected from the plurality of contact pads;
at least one second tamper evident line selected from the plurality of lines and connected to the at least one second tamper evident contact pad; and,
a second partially weakened portion of the flexible substrate arranged across the at least one second tamper evident line.

14. A container (350) comprising the flexible memory device of Claim 1.

15. The container of Claim 14 further comprising:
an enclosure comprising a sealed portion,
wherein the sealed portion is at least partially formed by the flexible memory device.

16. The container of Claim 15 wherein the enclosure is selected from: a bag; a carton; a box; a crate; a can; a bottle; and, an envelope.

## Patentansprüche

1. Flexible Speichervorrichtung (60), die umfasst:
ein flexibles Substrat (62);
eine Vielzahl von Kontaktflächen (64), die auf dem flexiblen Substrat (62) angeordnet sind;
eine Vielzahl von Leitungen (66), die auf dem flexiblen Substrat (62) angeordnet sind, wobei jede Leitung aus der Vielzahl von Leitungen (66) mit einer Kontaktfläche aus der Vielzahl von Kontaktflächen (64) verbunden ist;
**dadurch gekennzeichnet, dass:**
wenigstens eine Kontaktfläche aus der Vielzahl von Kontaktflächen (64) wenigstens eine erste manipulationssichere bzw. Originalitätskontaktfläche (78) bildet;
wenigstens eine Leitung aus der Vielzahl von Leitungen (66) wenigstens eine erste manipulationssichere Leitung (68) bildet und mit der wenigstens einen manipulationssicheren Kontaktfläche (78) verbunden ist;
ein erster teilweise geschwächter Abschnitt (70) des flexiblen Substrats (62), der über die wenigstens eine manipulationssichere Leitung (68) angeordnet ist.

2. Flexible Speichervorrichtung nach Anspruch 1, wobei die Vielzahl von Kontaktflächen (64) und die Vielzahl von Leitungen (68) angeordnet sind, um eine Vielzahl von Datenbits zu speichern.

3. Flexible Speichervorrichtung nach Anspruch 1, wobei der erste teilweise geschwächte Abschnitt (70) angeordnet ist, um das flexible Substrat (62) in einen ersten Teil und einen zweiten Teil zu trennen, wobei dadurch die wenigstens eine manipulationssichere Leitung (68) durchtrennt wird, während die Vielzahl von Leitungen außer der wenigstens einen manipulationssicheren Leitung intakt bleiben.

4. Flexible Speichervorrichtung nach Anspruch 3, wobei die Vielzahl von Kontaktflächen (64) außer der wenigstens einen ersten manipulationssicheren Kontaktfläche (78) und die Vielzahl von Leitungen (66) außer der wenigstens einen manipulationssicheren Leitung (68) wenigstens ein Datenbit nach dem Durchtrennen der wenigstens einen manipulationssicheren Leitung (68) speichern.

5. Flexible Speichervorrichtung von Anspruch 1, die des Weiteren umfasst:
zwei gemeinsame Kontaktflächen (77);
eine gemeinsame Leitung (76), die auf dem flexiblen Substrat (62) angeordnet und mit den beiden gemeinsamen Kontaktflächen (77) verbunden ist;
wobei jede aus der Vielzahl von Leitungen (66) über die gemeinsame Leitung (76) verläuft.

6. Flexible Speichervorrichtung nach Anspruch 5, wobei der erste teilweise geschwächte Abschnitt (70) angeordnet ist, um das flexible Substrat in einen ersten Teil und einen zweiten Teil zu trennen, ohne die gemeinsame Leitung (77) zu durchtrennen.

7. Flexible Speichervorrichtung nach Anspruch 1, wobei ein erster Abschnitt (123) aus der Vielzahl von Leitungen über einen zweiten Abschnitt (124) aus der Vielzahl von Leitungen verläuft und jede Leitung des ersten Abschnitts über jede Leitung des zweiten Abschnitts verläuft.

8. Flexible Speichervorrichtung nach Anspruch 7, wobei der erste teilweise geschwächte Abschnitt angeordnet ist, um das flexible Substrat in einen ersten Teil und einen zweiten Teil zu trennen, ohne einen Bereich zu durchtrennen, der mit dem ersten Abschnitt aus der Vielzahl von Leitungen gemeinsam ist, der über den zweiten Abschnitt der Vielzahl von Leitungen verläuft.

9. Flexible Speichervorrichtung nach Anspruch 1, wobei die Vielzahl von Kontaktflächen (64) zusammen einen Bereich bilden und der erste teilweise geschwächte Abschnitt (70) über den Bereich angeordnet ist.

10. Flexible Speichervorrichtung nach Anspruch 1, wobei der erste teilweise geschwächte Abschnitt (70) angeordnet ist, um das flexible Substrat (62) in einen ersten Teil und einen zweiten Teil zu trennen, wobei eine erste Gruppe aus der Vielzahl von Kontaktflächen auf dem ersten Teil und eine zweite Gruppe aus der Vielzahl von Kontaktflächen auf dem zweiten Teil angeordnet ist.

11. Flexible Speichervorrichtung nach Anspruch 1, wobei die Vielzahl von Kontaktflächen (64) zusammen einen Bereich bilden und der erste teilweise geschwächte Abschnitt (88) außerhalb des Bereiches angeordnet ist.

12. Flexible Speichervorrichtung nach Anspruch 1, wobei der erste teilweise geschwächte Abschnitt (88) angeordnet ist, um das flexible Substrat in einen ersten Teil und einen zweiten Teil zu trennen und die Vielzahl von Kontaktflächen (64) auf dem ersten Teil angeordnet ist.

13. Flexible Speichervorrichtung nach Anspruch 1, die des Weiteren umfasst:
wenigstens eine zweite manipulationssichere Kontaktfläche, die aus der Vielzahl von Kontaktflächen ausgewählt wird;
wenigstens eine zweite manipulationssichere Leitung, die aus der Vielzahl von Leitungen ausgewählt wird und mit der wenigstens einen zweiten manipulationssicheren Kontaktfläche verbunden ist; und
einen zweiten teilweise geschwächten Abschnitt des flexiblen Substrats, der über die wenigstens eine zweite manipulationssichere Leitung angeordnet ist.

14. Behälter (350), der die flexible Speichervorrichtung nach Anspruch 1 umfasst.

15. Behälter nach Anspruch 14, der des Weiteren umfasst:
eine Umhüllung, die einen versiegelten Abschnitt umfasst,
wobei der versiegelte Abschnitt wenigstens teilweise durch die flexible Speichervorrichtung gebildet wird.

16. Behälter von Anspruch 15, wobei die Umhüllung ausgewählt wird aus: einem Beutel; einem Karton; einer Schachtel; einer Kiste; einer Dose; einer Flasche und einer Hülle.

## Revendications

1. Dispositif de mémoire flexible (60) comprenant :
un substrat flexible (62) ;
une pluralité de tampons de contact (64) disposés sur le substrat flexible (62) ;
une pluralité de lignes (66) disposées sur le substrat flexible (62), où chaque ligne de la pluralité de lignes (66) est connectée à un tampon de contact de la pluralité de tampons de contact (64) ;
**caractérisé en ce que** :
au moins un tampon de contact de la pluralité de tampons de contact (64) forme au moins un premier tampon de contact inviolable (78) ;
au moins une ligne de la pluralité de lignes (66) forme au moins une première ligne inviolable (68) et est connectée à l'au moins un tampon de contact inviolable (78) ;
une première portion partiellement affaiblie (70) du substrat flexible (62) agencée en travers de l'au moins une ligne inviolable (68).

2. Dispositif de mémoire flexible selon la revendication 1 dans lequel la pluralité de tampons de contact (64) et la pluralité de lignes (68) sont agencés pour stocker une pluralité de bits de données.

3. Dispositif de mémoire flexible selon la revendication 1 dans lequel la première portion partiellement affaiblie (70) est agencée pour séparer le substrat flexible (62) en une première partie et une seconde partie, rompant ainsi l'au moins une ligne inviolable (68) tout en laissant la pluralité de lignes autres que l'au moins une ligne inviolable intactes.

4. Dispositif de mémoire flexible selon la revendication 3 dans lequel la pluralité de tampons de contact (64) autres que l'au moins un premier tampon de contact inviolable (78), et la pluralité de lignes (66) autres que l'au moins une ligne inviolable (68) stockent au moins un bit de données après la rupture de l'au moins une ligne inviolable (68).

5. Dispositif de mémoire flexible selon la revendication 1 comprenant en outre :
deux tampons de contact communs (77) ;
une ligne commune (76) disposée sur le substrat flexible (62) et connectée aux deux tampons de contact communs (77) ;
dans lequel chacune de la pluralité de lignes (66) passe au-dessus de la ligne commune (76).

6. Dispositif de mémoire flexible selon la revendication 5 dans lequel la première portion partiellement affaiblie (70) est agencée pour séparer le substrat flexible en une première partie et une seconde partie sans rompre la ligne commune (77).

7. Dispositif de mémoire flexible selon la revendication 1 dans lequel une première portion (123) de la pluralité de lignes passe au-dessus d'une seconde portion (124) de la pluralité de lignes, et chaque ligne de la première portion passe au-dessus de chaque ligne de la seconde portion.

8. Dispositif de mémoire flexible selon la revendication 7 dans lequel la première portion partiellement affaiblie est agencée pour séparer le substrat flexible en une première partie et une seconde partie sans rompre une zone commune à la première portion de la pluralité de lignes passant au-dessus de la seconde portion de la pluralité de lignes.

9. Dispositif de mémoire flexible selon la revendication 1 dans lequel la pluralité de tampons de contact (64) forment collectivement une zone, et la première portion partiellement affaiblie (70) est agencée en travers de la zone.

10. Dispositif de mémoire flexible selon la revendication 1 dans lequel la première portion partiellement affaiblie (70) est agencée pour séparer le substrat flexible (62) en une première partie et une seconde partie, un premier groupe de la pluralité de tampons de contact est disposé sur la première partie, et un second groupe de la pluralité de tampons de contact est disposé sur la seconde partie.

11. Dispositif de mémoire flexible selon la revendication 1 dans lequel la pluralité de tampons de contact (64) forment collectivement une zone, et la première portion partiellement affaiblie (88) est agencée à l'extérieur de la zone.

12. Dispositif de mémoire flexible selon la revendication 1 dans lequel la première portion partiellement affaiblie (88) est agencée pour séparer le substrat flexible en une première partie et une seconde partie et la pluralité de tampons de contact (64) sont disposés sur la première partie.

13. Dispositif de mémoire flexible selon la revendication 1 comprenant en outre :
au moins un second tampon de contact inviolable choisi parmi la pluralité de tampons de contact ;
au moins une seconde ligne inviolable choisie parmi la pluralité de lignes et connectée à l'au moins un second tampon de contact inviolable ; et,
une seconde portion partiellement affaiblie du substrat flexible agencée en travers de l'au moins une seconde ligne inviolable.

14. Conteneur (350) comprenant le dispositif de mémoire flexible selon la revendication 1.

15. Conteneur selon la revendication 14 comprenant en outre :
une enceinte comprenant une portion scellée,
dans lequel la portion scellée est au moins partiellement formée par le dispositif de mémoire flexible.

16. Conteneur selon la revendication 15 dans lequel l'enceinte est choisie parmi : un sac ; un carton ; une boîte ; un caisse ; un canette ; un bouteille ; et, une enveloppe.
